# EUROPEAN PATENT APPLICATION

(11) **EP 2 378 584 A1**
(43) Date of publication of application: **19.10.2011**
(21) Application number: 09834668.7
(22) Date of filing: 25.11.2009
(51) Int. Cl.: H01L 51/50, C07F 5/05

(54) **ORGANIC ELECTROLUMINESCENT ELEMENT**

(30) Priority: 26.12.2008 JP 2008334013
(71) Applicant: Pioneer Corporation, Kanagawa 212-0031 (JP); Nippon Steel Chemical Co., Ltd., Chiyoda-ku Tokyo 101-0021 (JP)
(72) Inventor: OYAMADA, Takahito, Tsurugashima-shi Saitama 350-2288 (JP); TSUJI, Taishi, Tsurugashima-shi Saitama 350-2288 (JP); KAI, Takahiro, Kita-Kyushu-shi Fukuoka 804-8503 (JP); OGAWA, Junya, Kita-Kyushu-shi Fukuoka 804-8503 (JP); SUDA, Mitsuru, Kita-Kyushu-shi Fukuoka 804-8503 (JP)
(74) Representative: Sauer, Philippe
(86) International application number: PCT/JP2009/069868
(87) International publication number: WO 2010/073864

(57) **Abstract**

[PROBLEM TO BE SOLVED] To provide an organic electroluminescence device with heat resistance capable of being driven by a low voltage.

[SOLUTION] An organic electroluminescence device includes a pair of anode and cathode opposed to each other; and a plurality of organic semiconductor layers layered or disposed between the anode and the cathode, the organic semiconductor layers including a light-emitting layer. At least one of the organic semiconductor layers contains a bulky organic semiconductor compound having an aromatic multi-membered ring structure and at least three aromatic substituents bonded thereto. Each of the aromatic substituents is arranged in a manner that a dihedral angle between a ring plane of the aromatic multi-membered ring structure and the ring plane of the aromatic substituent is within 70 to 90° determined by a semiempirical molecular orbital calculation method.

## Description

### TECHNICAL FIELD

The present invention relates to organic electroluminescence devices and particularly to an organic electroluminescence (abbreviated as EL) device comprising a plurality of layered organic material layers utilizing organic compounds having electric charge-transporting properties (hole mobility and/or electron mobility).

### BACKGROUND ART

generally, an organic EL device has a lamination structure of a plurality of layered organic material layers. The organic material layers includes an light-emitting layer and also a material layer having a hole-transporting capability such as a hole injection layer, a hole transport layer or the like, as well as another material layer having an electron transporting capability such as an electron transport layer, an electron injection layer or the like.

When an electric field is applied to the multilayered organic EL films including the light-emitting layer and electron or hole transport layers etc. being layered, then holes are injected from an anode as well as electrons are injected from a cathode and these are recombined in the light-emitting layer so that excitons are generated. When the excitons return from an excited state to a ground state, light is emitted. In order to improve a luminous efficiency of the device, it is important to efficiently move electrons or the like carriers to the interface of the light emitting layer. The organic light-emitting device also employs the multilayered structure utilizing organic compounds having charge-transporting properties i.e., electric charge transporting organic compounds.

It is well known that the organic EL device having the light-emitting layer of organic compounds is capable of a low voltage operation, but it is driven with a higher driving voltage in comparison with a light emitting diode or the like. There is a problem that a driving voltage of a phosphorescence organic EL device with a high quantum efficiency of light emission is higher than that of a fluorescence organic EL device.

generally it is possible to reduce a driving voltage by setting to decrease the thicknesses of organic layers in the organic EL device. In this case there is increase in occurrence of defectives electricity between both the electrodes, resulting in decrease of yields on products of the organic EL devices. There is an attempt to resolve such a problem has been made in a manner that a dopant is introduced into an adjacent layer to the electrode, i.e., a charge transport layer to raise the conductivity of the charge transport layer (See Patent Literature 1).

Patent Literature 2: Japanese Unexamined Patent Publication No. 10-270172

### DISCLOSURE OF THE INVENTION

### [Problem to be solved by the invention]

However, there are problems such as the cost of film-formation with a high temperature vacuum deposition for the dopants, the decomposition of such dopants deposited, the layer unclearness caused by generation of chelate complexes, a high voltage for driving the conventional organic EL device, and a short life time of the conventional organic EL device.

Accordingly, there is one of exemplary tasks to be achieved by the present invention to provide an organic EL device capable of being driven by a low applied voltage and having thick layered organic semiconductor layers with a high temperature preservation.

### [Means for solving the problem]

An organic electroluminescence device according to the present invention is an organic electroluminescence device comprising: a pair of anode and cathode opposed to each other; and a plurality of organic semiconductor layers layered or disposed between the anode and the cathode, the organic semiconductor layers including an light-emitting layer, wherein at least one of the organic semiconductor layers contains a bulky organic semiconductor compound having an aromatic multi-membered ring structure and at least three aromatic substituents bonded thereto, wherein each of the aromatic substituents is arranged in a manner that a dihedral angle between a ring plane of the aromatic multi-membered ring structure and the ring plane of the aromatic substituent is within 70 to 90° determined by a semiempirical molecular orbital calculation method.

In addition, an organic electroluminescence device according to the present invention is an organic electroluminescence device comprising: a pair of anode and cathode opposed to each other; and a plurality of organic semiconductor layers layered or disposed between the anode and the cathode, the organic semiconductor layers including an light-emitting layer, wherein at least one of the organic semiconductor layers contains a bulky organic semiconductor compound having an aromatic multi-membered ring structure and at least three aromatic substituents bonded thereto, wherein each of the aromatic substituents is arranged in a manner that a dihedral angle between a ring plane of the aromatic multi-membered ring structure and the ring plane of the aromatic substituent is within 70 to 90° determined by a semiempirical molecular orbital calculation method, wherein the organic semiconductor layer containing the bulky organic semiconductor compound or a neighboring layer thereof contains an inorganic fluoride or inorganic oxide.

The organic electroluminescence device according to the present invention enables emission with a high luminous and high efficiency for a long life time under a low driving voltage. Therefore the organic electroluminescence device according to the present invention can adapt to a flat panel display device (e.g., a PC monitor, a wall-mounted TV), avehicle-mountedmonitor, a mobile phone display, and further to a light source with a surface emitting characteristics (e.g., a copying machine light source, a back light source of LCD or meter instruments), and it is technically valuable.

### BRIEF DESCRIPTION OF THE DRAWINGS

FIG. 1 is a schematic partial cross section view showing an organic EL device according to an embodiment of the present invention.
FIG. 2 is a schematic partial cross section view showing an organic EL device according to another embodiment of the present invention.
FIG. 3 is a schematic partial cross section view showing an organic EL device according to another embodiment of the present invention.
FIG. 4 is a schematic partial cross section view showing an organic EL device according to another embodiment of the present invention.
FIG. 5 is a schematic partial cross section view showing an organic EL device according to another embodiment of the present invention.
FIG. 6 is a diagram illustrating a molecule of an electric charge-transporting material drawn by using a MOPAC (Molecular Orbital PACkage) computer program of the MO method.
FIG. 7 is a diagram illustrating a molecule of an electric charge-transporting material drawn by using a MOPAC computer program of the MO method.
FIG. 8 is a diagram illustrating a molecule of an electric charge-transporting material drawn by using a MOPAC computer program of the MO method.
FIG. 9 is a diagram illustrating a molecule of an electric charge-transporting material drawn by using a MOPAC computer program of the MO method.
FIG. 10 is a front view of an organic emitting device of Example 6 according to the present invention.
FIG. 11 is a front view of another organic emitting device of Example 6 according to the present invention.
FIG. 12 is a diagram illustrating a molecule of an electric charge-transporting material drawn by using a MOPAC computer program of the MO method.
FIG. 13 is a diagram illustrating a molecule of an electric charge-transporting material drawn by using a MOPAC computer program of the MO method.
FIG. 14 is a diagram illustrating a molecule of an electric charge-transporting material drawn by using a MOPAC computer program of the MO method.

### DETAILED DESCRIPTION OF THE INVENTION

The embodiments according to the present invention will be described herein below with reference to the drawings.

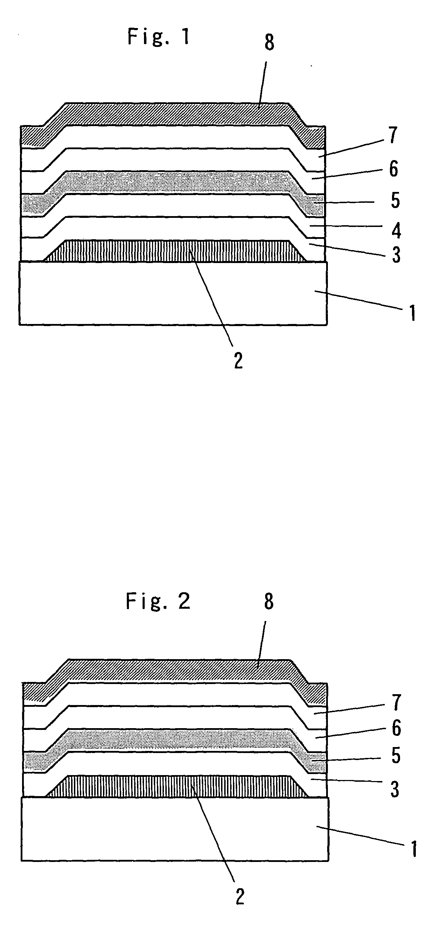

One example of organic EL devices of the embodiments, as shown in FIG. 1, comprises: a transparent anode 2; a hole transport layer 4; an light-emitting layer 5; an electron transport layer 6; an electron injection layer 7; and a cathode 8 made of metal, which are successively laminated on a transparent substrate 1 made of, for example, glass, plastic or the like. The hole transport layer 4, the light-emitting layer 5, the electron transport layer 6 and the electron injection layer 7 are organic semiconductor layers. Namely, the organic EL device includes: a pair of the anode and cathode opposed to each other; and a plurality of organic semiconductor layers layered or disposed therebetween which include the hole injection layer, the hole transport layer, and the light-emitting layer. The components of the organic semiconductor layers etc. will be described herein below in detail.

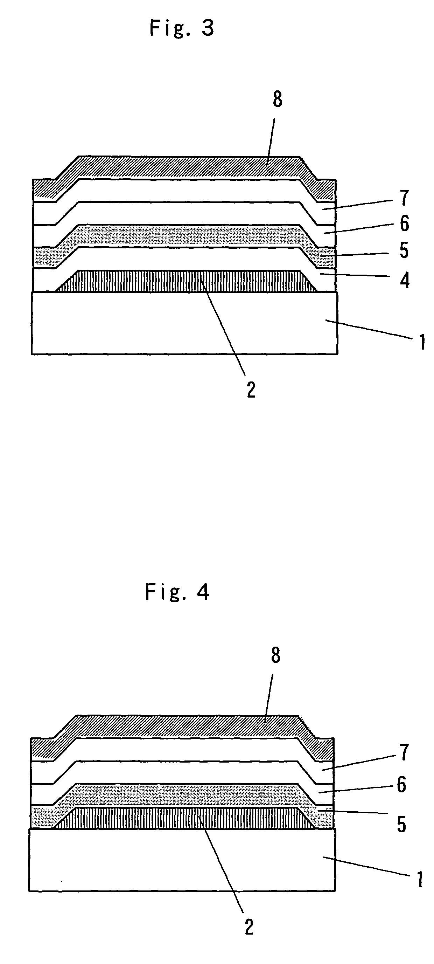

In addition to the layered structure of the anode 2 /hole injection layer 3 /hole transport layer 4 /light-emitting layer 5 /electron transport layer 6 /electron injection layer 7 /cathode 8 as shown in FIG. 1, there is a layered structure of the anode 2 /hole injection layer 3 /light-emitting layer 5 /electron transport layer 6 /electron injection layer 7/cathode 8 as shown in FIG. 2, included in the invention. The "/" denotes an interface between adjacent layers contacting one another. Furthermore, there are layered structures, e.g., FIG. 3 shows a structure of the anode 2 /hole transport layer 4 /light-emitting layer 5 /electron transport layer 6 /electron injection layer 7 /cathode 8; and FIG. 4 shows a structure of the anode 2 /light-emitting layer 5 /electron transport layer 6 /electron injection layer 7 /cathode 8, which are included in the invention.

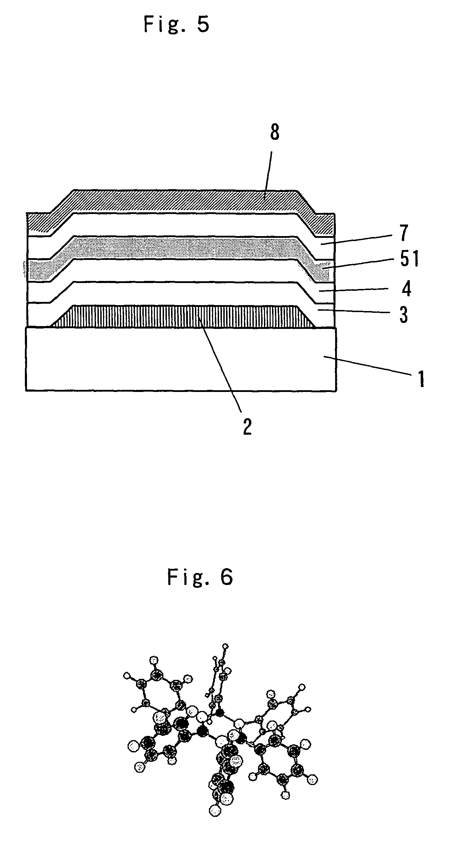

Moreover, as shown in FIG. 5, the invention includes a layered structure of the anode 2 /hole injection layer 3 /hole transport layer 4 /light-emitting layer 51 functioning as an electron transport layer /electron injection layer 7 /cathode 8. The scope of the present invention is by no means limited to those layered configuration. Another layered configuration e.g., hole-blocking layer and / or buffering layer (not shown) etc. is inserted to those layered configuration mentioned above.

### --SUBSTRATE, ANODE AND CATHODE --

The materials other than the glass transparent material used for the substrate 1 are transparent or semi-transparent materials e.g., thermoplastics resins such as polystyrene, polycarbonate, polycycloolefin, polymethylmethacrylate, or thermosetting resins such as phenolic resins, epoxy resins, and further opaque materials e.g., silicon, A1 or the like can be used.

The electrode materials of the anode 2 and the cathode 8 include metals or alloys thereof such as Ti, A1, A1, Cu, Ni, Ag, Mg:Ag, Au, Pt, Pd, Ir, Cr, Mo, W, Ta or the like or alloys thereof. Alternatively, conductive polymers such as polyaniline or PEDT:PSS can be used. Otherwise, an oxide transparent conductive thin film can be used whose main component is any of Indium Tin Oxide (ITO), Indium Zinc Oxide (IZO), Zinc Oxide, Tin Oxide or the like, for example. Furthermore, the thickness of each electrode is preferably on the order of 10 to 500 nm. The electrode material film is preferably manufactured by a method of vacuum deposition or sputtering.

It is preferable to use, for the anode 2, a selected conductive material having a high work function higher than that of the cathode 8. Furthermore, materials and/or thicknesses of the anode and cathode are selected and set so that a least one of the anode and cathode at the side to take out the emission of the light has to be transparent or semi-transparent. Specifically one or both of the anode and cathode is preferably made of a material having a transmissivity of at least 10% or more in the wavelength of light emitted from the light-emitting material.

As for the electron injection layer 7 to improve the electron-injection efficiency in the organic EL device, an inorganic the electron injection layer made of an alkaline metal or alkaline earth metal with a low work function or compounds thereof (e.g., CsF, Cs₂CO₃, Li₂O, LiF) or the like can be used.

There are used for electron donating materials of dopant (doped to the electron injection layer comprises, as a main component, one of the organic compounds capable of transporting electrons), e. g. , an alkaline metal such as Li, etc. and an alkaline earth metal such as Mg, etc. and an organic compound synthesized therewith, but such a dopant is not limited thereto. Especially, the metal with a high work function of 4.5eV or less such as Cs, Li, Na, K, Be, Mg, Ca, Sr, Ba, Y, La, Mg, Sm, Gd, Yb, or a compound synthesized therewith is preferably used for the dopant.

### -- ORGANIC SEMICONDUCTOR LAYER --

As for the materials as main components of the organic semiconductor layers including the hole injection layer 3, the hole transport layer 4, the light-emitting layer 5 and the electron injection layer 7, there are utilized organic compounds having the charge-transporting property (e.g., mobility of hole and/or electron).

As for phosphorescent organic compounds used for the light-emitting layer 5, Iridium complex such as Bis (3,5-difluoro-2-(2-pyridyl) phenyl- (2-carboxypyridyl) iridium III, Tris (2-phenylpyridine) iridium(III), Bis (2-phenylbenzothiazolato) (acetylacetonate) iridium(III), or Osmium complex such as Osmium(II) bis(3-trifluoromethyl -5-(2-pyridyl) -pyrazolate)dimethylphenylphosphine, or rare-earth element compounds such as Tris (dibenzoylmethane) phenanthroline europium(III), or Platinum complex such as 2,3,7,8,12,13,17,18-Octaethyl-21H, 23H- porphine platinum(II) etc. can be used.

In addition, as for organic compounds capable of transporting electrons each amain component of the light-emitting layer or the electron transport layer or the electron injection layer, such as polycyclic compounds such as p-terphenyl, quaterphenyl, etc. as well as derivatives thereof, condensed polycyclic hydrocarbon compounds such as naphthalene, tetracene, pyrene, coronene, chrysene, anthracene, diphenylanthracene, naphthacene, phenanthrene, etc. as well as derivatives thereof, or condensed heterocyclic compounds such as phenanthroline, bathophenanthroline, phenanthridine, acridine, quinoline, quinoxaline, phenazine, etc. as well as derivatives thereof, and fluoroceine, perylene, phthaloperylene, naphthaloperylene, perynone, phthaloperynone, naphthaloperylene, diphenylbutadiene, tetraphenylbutadiene, oxadiazole, aldazine, bisbenzoxazoline, bisstyryl, pyrazine, cyclopentadiene, oxine, aminoquinoline, imine, diphenylethylene, vinylanthracene, diaminocarbazole, pyrane, thiopyrane, polymethine, merocyanine, quinacridone, rubrene, etc. as well as derivatives thereof can be used.

In addition, other organic compounds capable of transporting electrons, such as metal- chelated complex compounds, suitable metal-chelated oxanoide compounds are metal complexes which contain, as a ligand thereof, at least one selected from 8-quinolinolato and derivatives thereof such as tris(8-quinolinolato) aluminum, bis(8-quinolinolato) magnesium, bis[benzo(f)-8-quinolinolato] zinc, bis(2-methyl-8-quinolinolato) aluminum, tri(8-quinolinolato) indium, tris(5-methyl-8-quinolinolato) aluminum, 8-quinolinolato lithium, tris(5-chloro-8-quinolinolato) gallium, bis(5-chloro-8-quinolinolato) calcium or the like can be used.

In addition, other organic compounds capable of transporting electrons, such as oxadiazoles, triazines, stilbene derivatives and distyrylarylene derivatives, styryl derivatives, diolefin derivatives can be used preferably.

Furthermore, other organic compounds capable of transporting electrons, such as the group of benzoxazoles such as 2,5-bis (5,7-di-t-pentyl-2-benzoxazolyl)-1,3,4-thiazole, 4,4'-bis(5,7-t-pentyl-2-benzoxazolyl) stilbene, 4,4'-bis[5,7-di(2-methyl-2-butyl)-2-benzoxazolyl] stilbene, 2,5-bis(5,7-di-t-pentyl-2-benzoxazolyl) thiophene, 2,5-bis[5-(α,α-dimethylbenzyl)-2-benzoxazolyl] thiophene, 2,5-bis[5,7-di(2-methyl-2-butyl)-2-benzoxazolyl]-3,4-dipheny lthiophene, 2,5-bis(5-methyl-2-benzoxazolyl) thiophene, 4,4'-bis(2-benzoxazolyl) biphenyl, 5-methyl-2-{2-[4-(5-methyl-2-benzoxazolyl)phenyl]vinyl} benzoxazole, 2-[2-(4-chlorophenyl)vinyl]naphtho(1,2-d)oxazole, etc.; and the group of benzothiazoles such as 2,2'-(p-phenylenedipynylene)-bisbenzo thiazole, etc.; and the group of benzoimidazoles such as 2-{2-[4-(2-benzoimidazolyl)phenyl]vinyl}benzoimidazole, 2-[2-(4-carboxyphenyl)vinyl]benzoimidazole, etc. can be used.

Furthermore, other organic compounds capable of transporting electrons, such as 1,4-bis(2-methylstyryl) benzene, 1,4-bis(3-methylstyryl)benzene, 1,4-bis(4-methylstyryl)benzene, distyrylbenzene, 1,4-bis(2-ethylstyryl)benzene, 1,4-bis(3-ethylstyryl)benzene, 1,4-bis(2-methylstyryl)-2-methylbenzene, 1,4-bis (2-methylstyryl)-2-ethylbenzene or the like can be used.

In addition, other organic compounds capable of transporting electrons,such as 2,5-bis (4-methylstyryl) pyrazine, 2,5-bis(4-ethylstyryl)pyrazine, 2,5-bis[2-(1-naphthyl)vinyl]pyrazine, 2,5-bis(4-methoxystyryl)pyrazine, 2,5-bis[2-(4-biphenyl)vinyl]pyrazine, 2,5-bis[2-(1-pyrenyl)vinyl]pyrazine or the like can be used.

Furthermore, other organic compounds capable of transporting electrons, such as 1,4-phenylene-dimethylidine, 4,4'-phenylenedimethylidine, 2,5-xylylene-dimethylidine, 2,6-naphthylenedimethylidine, 1,4-biphenylene-dimethylidine, 1,4-p-terephenylenedimethylidine, 9,10-anthracenediyldimethylidine, 4,4`-(2,2-di-t-butylphenylvinyl)biphenyl, 4,4'-(2,2-diphenylvinyl)biphenyl or the like can be used. In addition to these organic compounds, any of the well-known compounds conventionally used in the production of the prior art organic EL devices may be suitably used.

Whereas, organic compounds capable of transporting holes, such as N,N,N',N'-tetraphenyl-4,4'-diaminophenyl, N,N'-diphenyl-N,N'-di(3-methylphenyl)-4,4'-diaminobiphenyl, 2,2-bis(4-di-p-tolylaminophenyl)propane, N,N,N',N'-tetra-p-tolyl-4,4'-diaminobiphenyl, bis(4-di-p-tolylaminophenyl)phenylmethane, N,N'-diphenyl-N,N'-di(4-methoxyphenyl)-4,4'-diaminobiphenyl, N,N,N',N'-tetraphenyl-4,4'-diaminodiphenylether, 4,4'-bis(diphenylamino)quadriphenyl, 4-N,N-diphenylamino-(2-diphenylvinyl)benzene, 3-methoxy-4'-N,N-diphenylaminostilbenzene, N-phenylcarbazole, 1,1-bis(4-di-p-triaminophenyl)cyclohexane, 1,1-bis(4-di-p-triaminophenyl)-4-phenylcyclohexane, bis(4-dimethylamino-2-methylphenyl)phenylmethane, N,N,N-tri(p-tolyl)amine, 4-(di-p-tolylamino)-4'-[4-(di-p-tolylamino)styryl]stilbene, N,N,N',N'-tetraphenyl-4,4'-diaminobiphenyl N-phenylcarbazole, 4,4'-bis[N-(1-naphthyl)-N-phenylamino]biphenyl, 4,4"-bis[N-(1-naphthyl)-N-phenylamino] p-terphenyl, 4,4'-bis[N-(2-naphthyl)-N-phenylamino]biphenyl, 4,4'-bis[N-(3-acenaphthenyl)-N-phenylamino]naphthalene, 4,4'-bis[N-(9-anthryl)-N-phenylamino]biphenyl, 4,4"-bis[N-(1-anthryl)-N-phenylamino] p-terphenyl, 4,4'-bis[N-(2-phenanthryl)-N-phenylamino]biphenyl, 4,4'-bis[N-(8-fluoranthenyl)-N-phenylamino]biphenyl, 4,4'-bis[N-(2-pyrenyl)-N-phenylamino]biphenyl, 4,4'-bis[N-(2-perylenyl)-N-phenylamino]biphenyl, 4,4'-bis[N-(1-coronenyl)-N-phenylamino]biphenyl, 2,6-bis(di-p-tolylamino)naphthalene, 2,6-bis[di-(1-naphthyl)amino]naphthalene, 2,6-bis[N-(1-naphthyl)-N-(2-naphthyl)amino]naphthalene, 4,4"-bis[N,N-di(2-naphthyl)amino]terphenyl, 4,4'-bis{N-phenyl-N-[4-(1-naphthyl)phenyl]amino}biphenyl, 4,4'-bis[N-phenyl-N-(2-pyrenyl)amino]biphenyl, 2,6-bis[N,N-di(2-naphthyl)amino]fluorene, 4,4"-bis(N,N-di-p-tolylamino)terphenyl, bis(N-1-naphthyl) (N-2-naphthyl)amine or the like can be used.

Further, in the case of formation of the hole injection layer, the hole transport layer and the hole-transporting luminescent layer, a dispersion of the above-described organic compounds in a polymer or a polymerized product of such organic compounds may be used. Moreover, so-called "n-conjugate polymers" such as polyparaphenylene vinylene and its derivatives, hole-transporting non-conjugate polymers, one typical example of which is poly(N-vinylcarbazole), and σ-conjugate polymers of polysilanes may be used for the same purpose.

For the material of the hole injection layer, which is not restricted to a specific one, metal phthalocyanines such as copper phthalocyanine (CuPc), a Copper complex, etc. as well as non-metal phthalocyanines, and electrically conducting polymers such as carbon films, polyanilines, etc. may be suitably used in the formation thereof.

### --Bulky organic semiconductor compound of multi-membered ring structure--

The inventors have had an interesting observation on a molecule having peculiar bulky aromatic substituents (i. e. , bulky organic semiconductor compounds as an electric charge-transporting material to drive devices with a low driving voltage), and further taken attention to the aromatic substituents placed nearly perpendicular to an aromatic multi-membered ring structure in the bulky organic semiconductor compound, such that the inventors have made experiments by doping a inorganic compound at a low concentration into the electron injection layer or electron transport layer and tested a high temperature storage of devices to improve the device properties in a driving life span and a high temperature storage. Upon searching the organic compounds having electric charge-transporting properties (hole mobility and/or electron mobility) for materials of aromatic multi-membered ring or condensed aromatic ring, the inventors found from the experiment results above that it is preferable to use a bulky organic semiconductor compound having an aromatic multi-membered ring structure and at least three aromatic substituents bonded thereto, wherein each of the aromatic substituents is arranged in a manner that a dihedral angle between a ring plane of the aromatic multi-membered ring structure and the ring plane of the aromatic substituent is within 70 to 90° determined by a semiempirical molecular orbital calculation method.

The inventors have performed the geometry optimization (on the dihedral angle) using the semiempirical molecular orbital calculation method e.g., MOPAC (Molecular Orbital PACkage) computer program (MOPAC Ver. 6), the AM1 method, and the PM3 method to calculate a weighted hydrogen bond. As for an initial coordinate of input data about the borazine ring structure, the C-C bond of 1.4 Angstroms, the C-H bond of 1.1 Angstroms, and the bond angle of 120° ware used in the geometry optimization. The molecular orbital calculation method is a mathematical function describing a molecular state using the distribution of electrons throughout molecule or orbital function of electron space on the basis of solving the Schrödinger equation. For this there are known approximations such as the empirical molecular orbital calculation method, the nonempirical molecular orbital calculation method, and the semiempirical molecular orbital calculation method. Since the semiempirical molecular orbital calculation method uses many of the same mathematics of semiempirical parameters as are found in the Hartree-Fock method, for the calculation of molecular electron states, to obtain reduction in computational complexity in comparison with the nonempirical molecular orbital calculation method, it is advantageous to deal with a large molecule.

As long as the bulky organic semiconductor compound has an aromatic multi-membered ring structure and at least three aromatic substituents bonded thereto, wherein each of the aromatic substituents is arranged in a manner that a dihedral angle between a ring plane of the aromatic multi-membered ring structure and the ring plane of the aromatic substituent is within 70 to 90° determined by a semiempirical molecular orbital calculation method, the bulky organic semiconductor compound is not limited. It is preferable that the sum of areas of the ring planes of the aromatic substituents is larger than an area of the ring plane of the aromatic multi-membered ring structure, each ring plane of the aromatic substituent having a dihedral angle of 70 to 90° with respect to the ring plane of the aromatic multi-membered ring structure.

As for the bulky organic semiconductor compound, there are borazine compounds each having an aromatic multi-membered ring structure represented by the following general chemical formula (1).

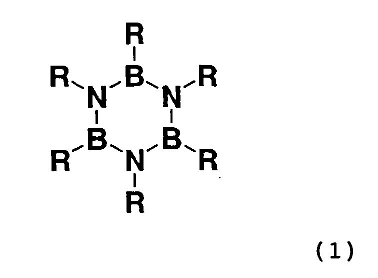

In the formula (1), N denotes a nitrogen atom; B denotes a boron atom; R denotes a hydrogen atom, an aryl group, a heteroaryl group, an oligoaryl group or an oligoheteroaryl group; R may be different or same and at least three of R or more are not hydrogen atoms. Desirable groups of R are a phenyl group, a naphthyl group, a phenanthryl group, an anthryl group, a pyridyl group, a pyrimidyl group, a triazyl group, a quinolyl group, and an isoquinolyl group, and further a phenyl group, a naphthyl group, and a pyridyl group can be used preferably.

Specifically, as for the foregoing bulky organic semiconductor compound, there are borazine compounds listed below.

Compound 1 mentioned below is B,B',B"-triphenyl-N,N',N"-triphenylborazine, a molecular illustration of which is shown in FIG. 6 drawn by the MOPAC (Molecular Orbital PACkage) computer program.

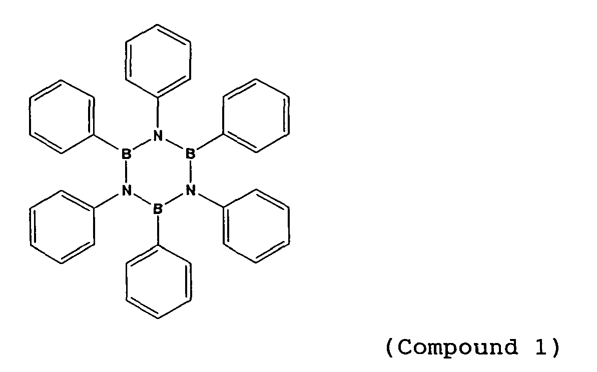

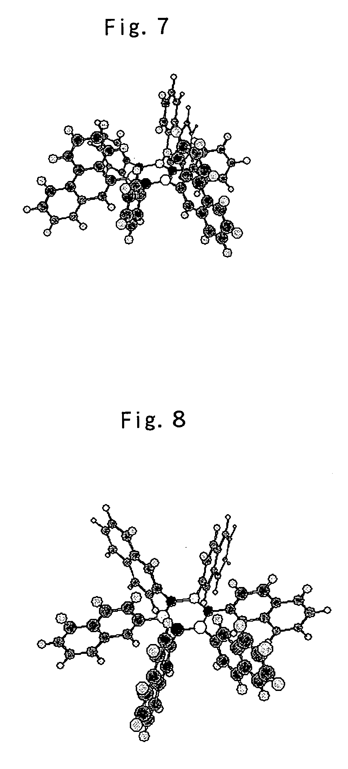

Compound 2 mentioned below is B,B',B"-tri(9-phenanthryl)-N,N',N"-triphenylborazine, a molecular illustration of which is shown in FIG. 7 drawn by the MOPAC (Molecular Orbital PACkage) computer program.

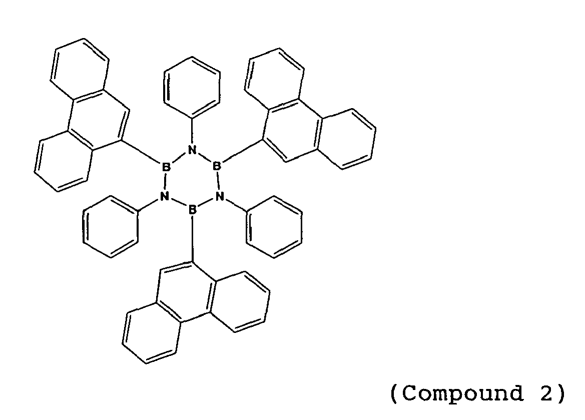

Compound 3 mentioned below is B,B',B"-tri(2-naphthyl)-N,N',N"-tri(2-naphthyl)borazine, a molecular illustration of which is shown in FIG. 8 drawn by the MOPAC (Molecular Orbital PACkage) computer program.

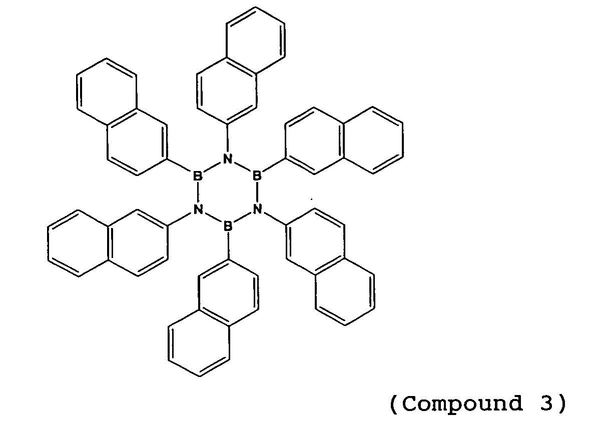

In addition, as for the bulky organic semiconductor compound, there are benzene compounds each having an aromatic multi-membered ring structure represented by the following general chemical formula (2).

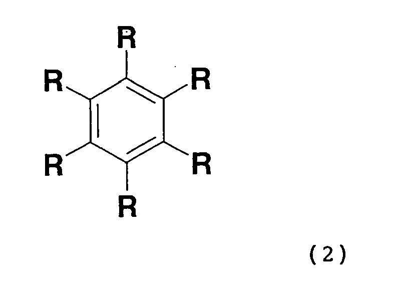

In the formula (2), R denotes hydrogen atom, an aryl group, aheteroarylgroup, an oligoaryl group or an oligoheteroaryl group; R may be different or same and at least three of R or more are not hydrogen atoms. Desirable groups of R are a phenyl group, a naphthyl group, a phenanthryl group, an anthryl group, a pyridyl group, a pyrimidyl group, a triazyl group, a quinolyl group, an isoquinolyl group, and further, a phenyl group, a naphthyl group, a pyridyl group can be used preferably.

Specifically, as for the foregoing bulky organic semiconductor compound, there are benzene compounds listed below.

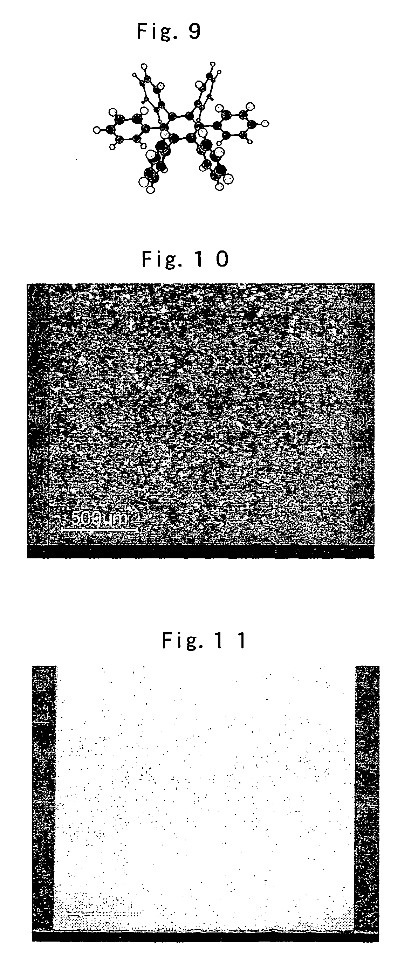

Compound 4 mentioned below is Hexaphenylbenzene, a molecular illustration of which is shown in FIG. 9 drawn by the MOPAC computer program.

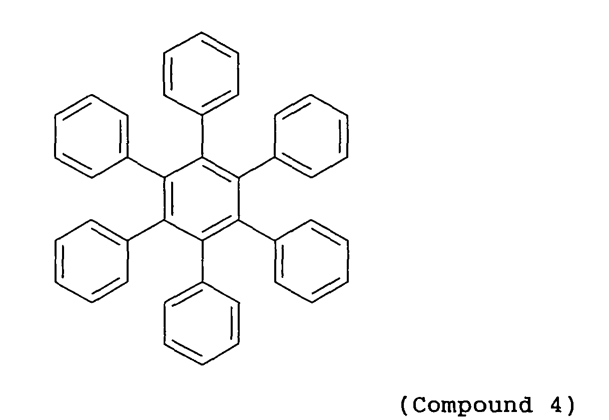

In addition, Compounds 5 and 6 mentioned below are 1,2,4,5-tetraphenylborazine (the dihedral angle: about 80°), 1,3,5-tri(9-anthryl)borazine (the dihedral angle: about 80°), and Compounds 7 to 12 of benzene compounds mentioned below, but the benzene compounds are not limited to these Compounds.

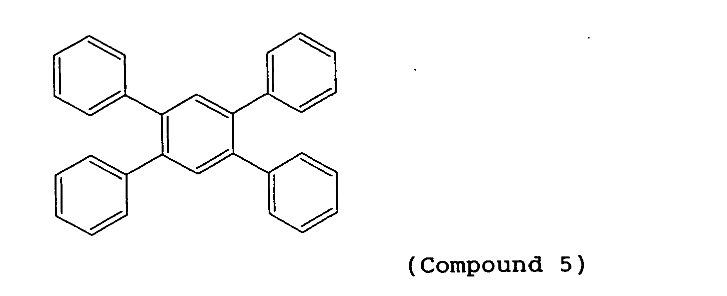

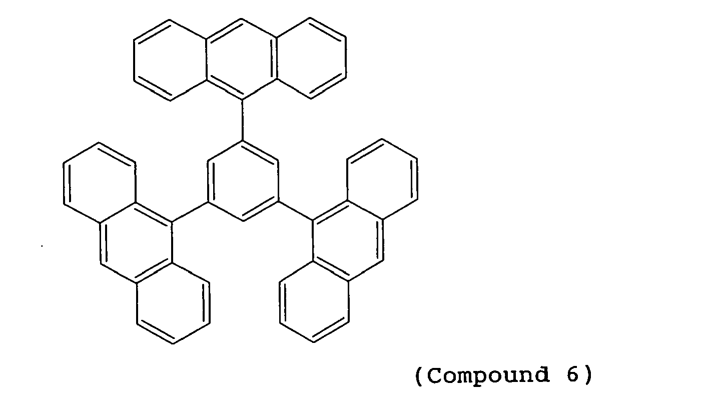

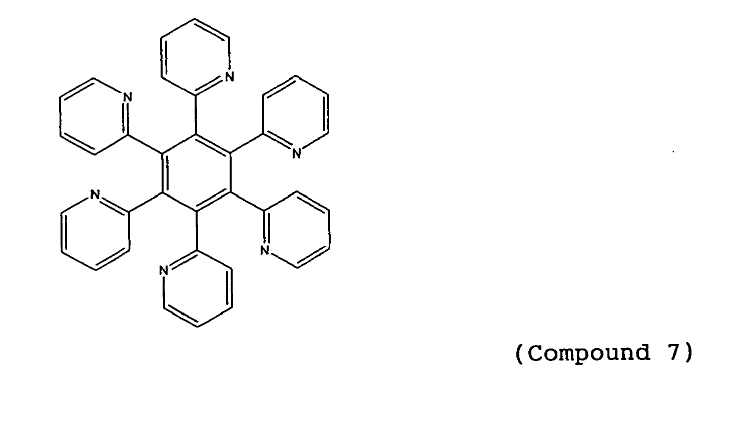

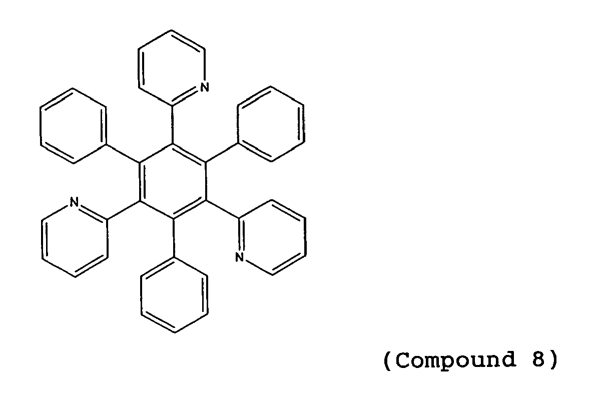

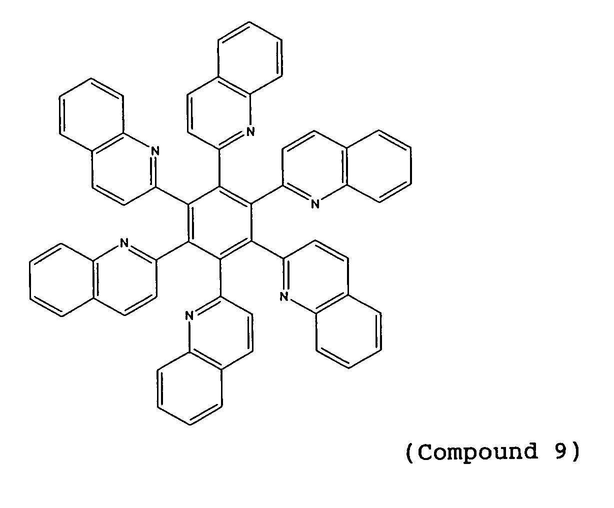

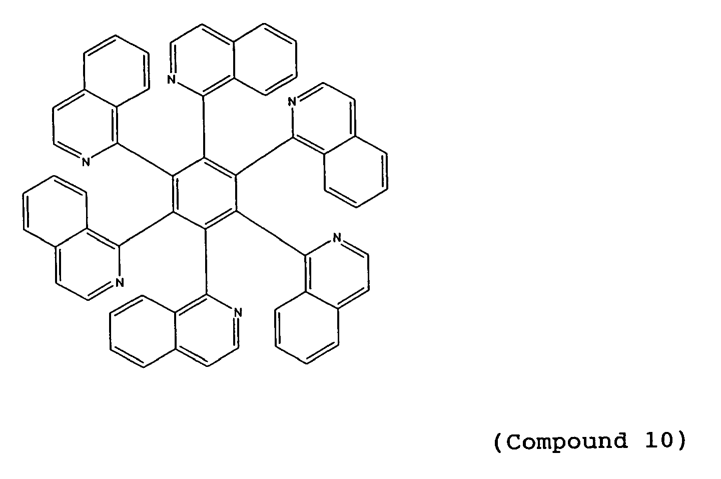

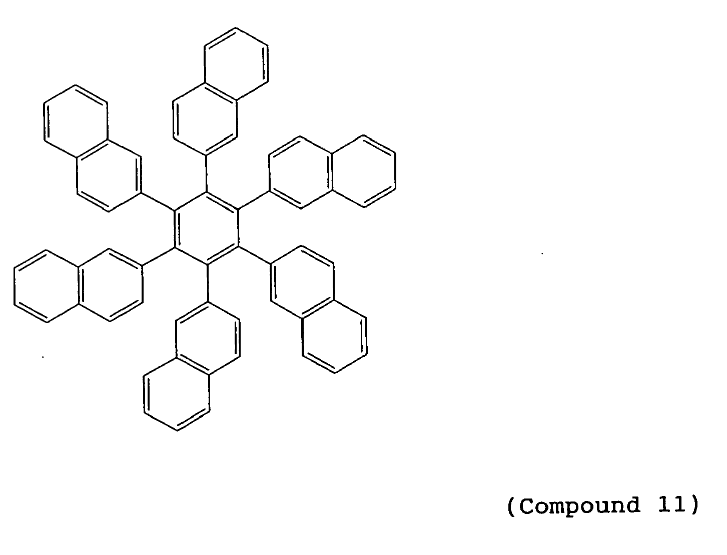

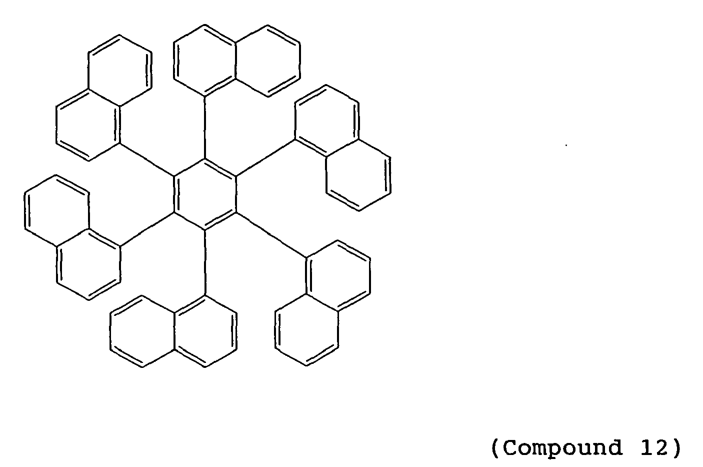

In addition, as for the foregoing bulky organic semiconductor compound, Compounds 13 to 15 mentioned below may be used, which have a structure that the central skeleton of the benzene compound represented by the general chemical formula (2) is replaced with a heteroaromatic ring such as pyridine ring etc.

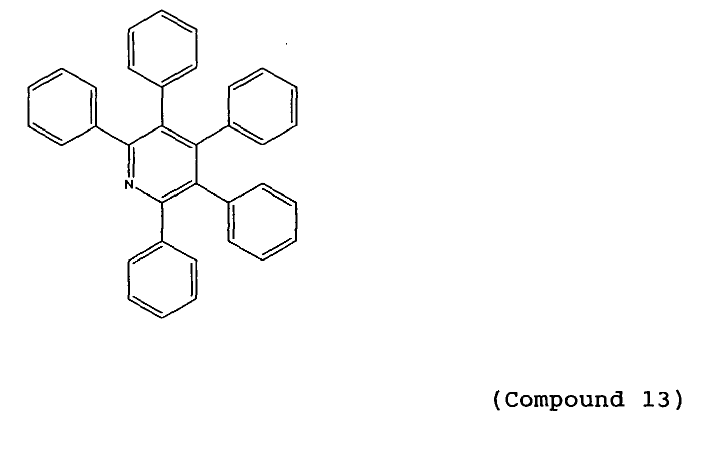

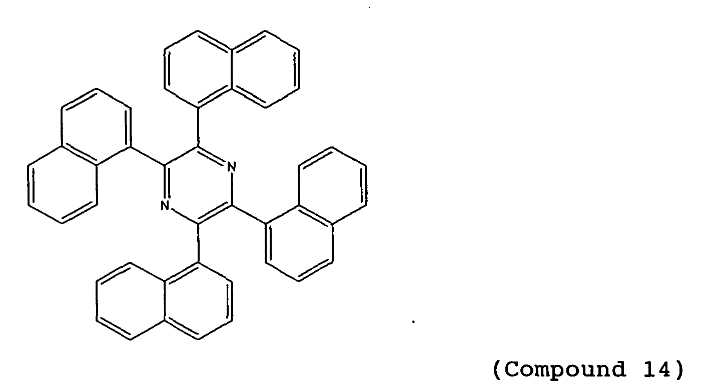

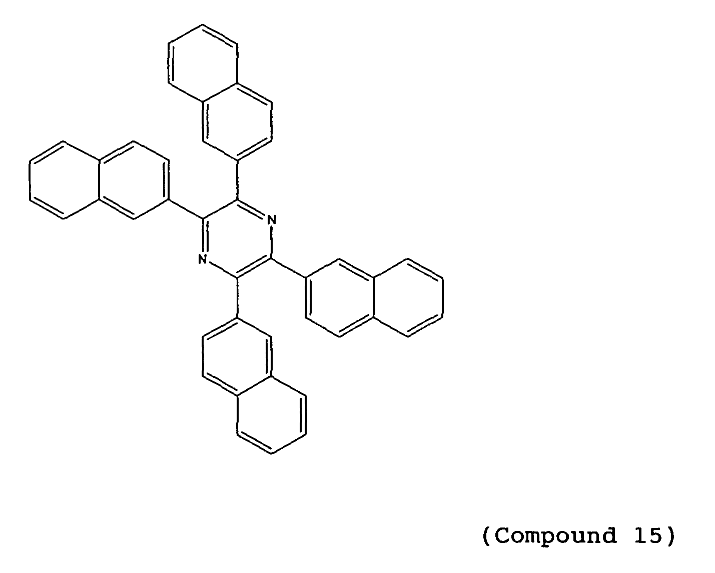

Moreover, as for the foregoing bulky organic semiconductor compound, Compounds 16 and 17 of Octaphenylnaphthalene and 2,3,6,7-tetraphenylnaphthalene (the dihedral angle: about 80°) mentioned below may be used, which have a structure that the central skeleton of the benzene compound represented by the general chemical formula (2)is replaced with a condensed aromatic ring such as naphthalene etc.

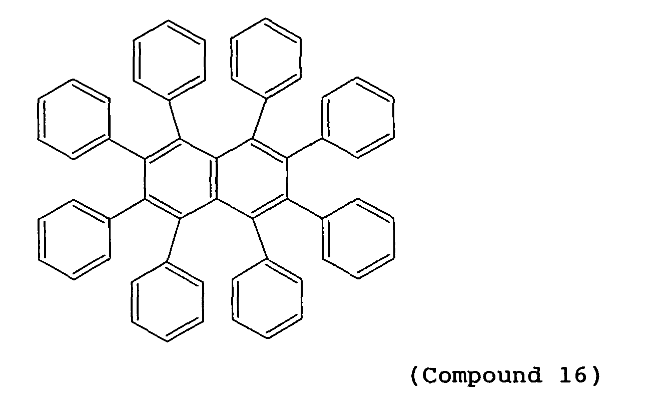

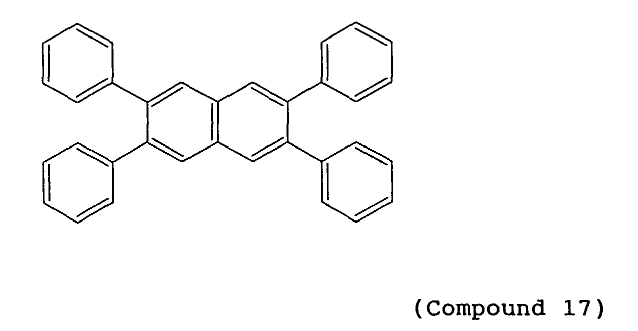

In addition, it is more preferable that the organic semiconductor layer containing the bulky organic semiconductor compound or a neighboring layer thereof contains an inorganic fluoride or inorganic oxide.

Preferable inorganic fluorides are AlF₃, MgF₂ etc. and preferable inorganic oxide are molybdenum oxide, vanadium oxide etc.

In case that the inorganic fluoride or inorganic oxide is doped to the organic semiconductor layer containing the bulky organic semiconductor compound, the concentration thereof is preferably 2.5 to 40vol% more preferably 5 to 40vol%.

In addition, in case that a neighboring layer of the organic semiconductor layer containing the bulky organic semiconductor compound contains an inorganic fluoride or inorganic oxide, it is preferable that the neighboring layer containing an inorganic fluoride or inorganic oxide is formed to have a thickness ranging from 1 to 60nm, but such a ranging is not limited thereto since it is relative to the total thickness of the device, the balance of electric charges in materials of the other layer adapted to the usage, the purpose, etc.

To neighbor a layer containing an inorganic fluoride or inorganic oxide, alternatively to add those inorganic compounds to the bulky organic semiconductor compound improves the adhesive strength to the transparent electrode to repress the peeling and crystallization at the interface caused by heat during the driving thereof or under a high temperature storage environment, resulting in reducing traps of obstruction to the electric charge transporting to restrain the raise of the driving voltage, so that an organic electroluminescence device with a high reliability is realized.

Next, Examples according to the present invention are explained in more detail, but the present invention is not especially limited to the Examples.

### --Example 1: (Performance evaluation of Devices using a bulky organic semiconductor compound as an electron injection layer)--

A plurality of organic EL devices were fabricated in a manner described bellow and then the life span properties thereof were measured and evaluated.

### --Elementary device 1-1 (ref)

There was provided a glass substrate on which an anode of transparent electrode ITO was formed. Through a vacuum deposition method, in sequence, a hole injection layer of Copper Phthalocyanine (CuPc) with a thickness of 32nm was formed on the anode, and then a hole transport layer of N,N'-bis(naphthalene-2-yl)-N,N'-diphenyl-benzidene (abbreviated as NPB) with a thickness of 38nm was formed on the hole injection layer, and then a light-emitting layer functioning as an electron transport layer of Tris(8-hydroxyquinolinato)aluminum(III) (abbreviated as Alq3) with a thickness of 60nm was formed on the hole transport layer, and then an electron injection layer Li₂O (with a 10nm thickness) and a cathode of A1 (with a 80nm thickness) were formed thereon serially. This fabricated Elementary device 1-1 became a reference device.

### --The device 1-2 (Comparison device 1)--

An organic EL device 1-2 was fabricated in the same manner as the Elementary device 1-1, except that an electron injection layer of (N,N' -bis-(4-diphenylamino-4-biphenyl)-N,N' -diphenylbenzidine) (abbreviated as TPT-1) was formed with a thickness of 32nm and then a hole transport layer of NPB was formed with a thickness of 38nm thereon, wherein TPT-1 does not have an aromatic substituent with a dihedral angle of 70 to 90°.

### --The device 1-3 (Comparison device 2)--

An organic EL device 1-3 was fabricated in the same manner as the Elementary device 1-1, except that an electron injection layer of NPB and a hole transport layer of NPB were formed with thickness of 32nm and 38nm(the sum of 70nm) respectively, wherein NPB does not have an aromatic substituent with a dihedral angle of 70 to 90°.

### --The device 1-4 (Comparison device 3)--

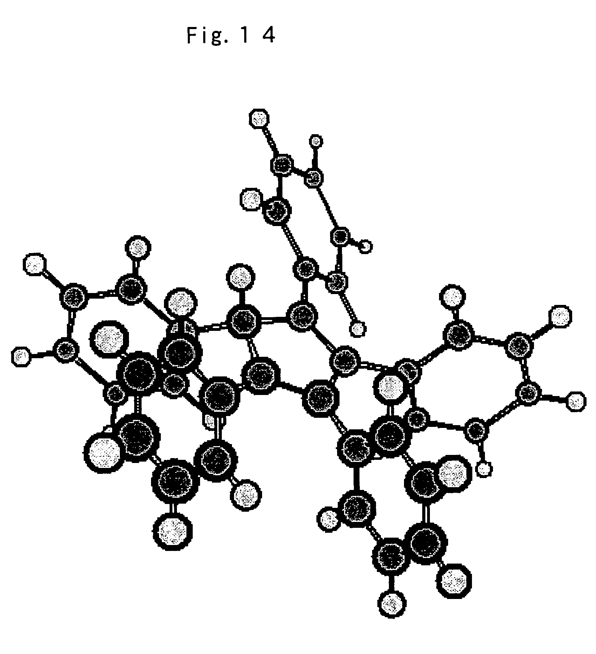

An organic EL device 1-4 was fabricated in the same manner as the Elementary device 1-1, except that an electron injection layer of a cyclopentadiene compound was formed with a thickness of 32nm and then a hole transport layer of NPB was formed with a thickness of 38nm thereon, wherein the cyclopentadiene compound without an aromatic multi-membered ring structure for a central skeleton is represented by the chemical formula below. FIG. 14 shows an illustration of a molecular structure (MO) of the cyclopentadiene compound of 1,2,3,4,5-pentaphenyl-1,3-cyclopentadiene drawn by using a MOPAC (Molecular Orbital PACkage) computer program of the MO method.

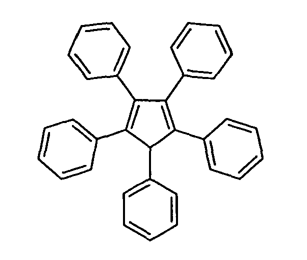

### --The device 1-5 (Example 1)--

An organic EL device 1-5 was fabricated in the same manner as the Elementary device 1-1, except that an electron injection layer of Hexaphenylbenzene (Compound 4) of a benzene compound was formed with a thickness of 32nm and then a hole transport layer of NPB was formed with a thickness of 38nm thereon.

### --The device 1-6 (Example 2)--

An organic EL device 1-6 was fabricated in the same manner as the Elementary device 1-1, except that an electron injection layer of B,B',B"-triphenyl-N,N',N"-triphenylborazine (Compound 1) of a borazine compound was formed with a thickness of 32nm and then a hole transport layer of NPB was formed with a thickness of 38nm thereon.

The device structures of from the Elementary device 1-1 to the device 1-6 are listed as follows.
Device No.: Anode /Hole injection layer /Hole transport layer /Light-emitting layer functioning as an electron transport layer /Electron injection layer/Cathode
The device 1-1: ITO/CuPc/NPB/Alq3/Li₂O/Al
The device 1-2: ITO/TPT-1/NPB/Alq3/Li₂O/Al
The device 1-3: ITO/NPB/NPB/Alq3/Li₂O/Al
The device 1-4: ITO/Cyclopentadiene compound /NPB/Alq3/Li₂O/Al
The device 1-5: ITO/Compound 4/NPB/Alq3/Li₂O /Al
The device 1-6: ITO/Compound 1/NPB/Alq3/Li₂O /A1.

As for the Elementary device 1-1 to the device 1-6, these were driven respectively under a condition of a predetermined current density of at a high temperature storage environment (85°C, 100°C, 100 hours), and then initial driving voltages, initial luminance, changes of driving voltage and changes of luminance of those devices were measured respectively.

The tested results are shown in the following Table 1, in the judgment of high temperature storage, the device having a change of driving voltage lower than +0.5V is denoted by ○, else X. In the driving life span, the device having a performance equal to or higher than that of Elementary device 1-1(ref) in the luminance inferiority is denoted by ○, else ×. HIL represents the electron injection layer and HTL represents the hole transport layer.

**Table 1**

| Device | HIL | HTL | Initial Driv. volt. @ 7.5mA/cm² (V) | Initial lum. @ 7.5mA/cm² L(cd/m²) | High temp. storage (85°C) 100 hours | | Judgment (85°C) | Driv. life span @21mA/cm² | Overall judgment |
|---|---|---|---|---|---|---|---|---|---|
| | | | | | Voltage change @7.5mA/cm² | Lum. change @7.5mA/cm² | | | |
| 1-1 (ref) | CuPc (32nm) | NPB (38nm) | 5.52 | 310 | +0.1 | +3 | ○ | ○ | ref |
| 1-2 (Compar. 1) | TPT-1 (32nm) | ↑ (38nm) | 4.90 | 290 | +1.8 | -90 | × | × | × |
| 1-3 (Compar. 2) | NpB (32nm) | ↑ | 4.40 | 323 | +1.7 | -73 | × | × | × |
| 1-4 (Compar. 3) | Cyclopenta diene (32nm) | ↑ | 17.1 | 380 | +1.5 | +50 | × | × | × |
| 1-5 (Ex. 1) | Comp.4 (32nm) | ↑ | 3.73 | 287 | +1.4 | -55 | × | × | Δ |
| 1-6 (Ex. 2) | comp. 1 (32nm) | ↑ | 3.57 | 247 | +1.3 | +40 | × | × | Δ |

In addition, Table 2 shows physical properties of materials used for the electron injection layer in the devices.

**Table 2**

| Device | HIL | HOMO (eV) | Hole mobility (cm²/Vs) | Glass transition temperature (°C) |
|---|---|---|---|---|
| 1-1 (ref) | CuPc | 5.1 | ~2X10⁻² | >200 |
| 1-2 (Compar. 1) | TPT-1 | 5.3 | 7X10⁻³ | 144 |
| 1-3 (Compar. 2) | NPB | 5.4 | 2X10⁻³ | 98 |
| 1-4(Compar. 3) | Cyclopentadiene | 6.7 | ND | ND |
| 1-5 (Ex. 1) | Comp. 4 | 6. 6 | 7X10⁻⁶ | 85 |
| 1-6 (Ex. 2) | Comp. 1 | 6.8 | ND | 85 |

As seen from these results, it is expected the respective devices having the electron injection layers including Compound 4 and Compound 1 can be driven with a low deriving voltage in comparison with the other devices including other compound. Generally a high mobility martial whose HOMO is adjacent at 5eV is suitable for the hole injection layer in order that holes are injected from the anode (ITO), and there is a consideration the driving voltage will be reduced suitably by the use of CuPc such a material. Notwithstanding Compound 4 and Compound 1 fall into such category material, they contribute to realize a low voltage driving of the device in comparison with CuPc, as seen from the Tables 1 and 2 . Particularly, as seen from the result of Comparison device 3, the cyclopentadiene compound having a deep HOMO and a poor aromaticity does not contribute to realize a low voltage driving of the device. In addition, it is understood that the organic semiconductor layer containing the bulky organic semiconductor compound of the benzene compound or the borazine compound is suitably placed as a hole transport layer or electron injection layer between the light-emitting layer and the anode.

### - -Example 2: (Performance valuation of the device including, as an electron injection layer, a bulky organic semiconductor compound layer or an inorganic compound layer layered)--

A plurality of organic EL devices were fabricated in a manner described bellow and then the life span properties thereof were measured and evaluated, each of which includes an electron injection layer of inorganic compound layer (inorganic fluoride or inorganic oxide) and/or a bulky organic semiconductor compound layer (Compound 1 or Compound 4) layered.

Similarly to Example 1, the devices were based on Elementary device 1-1.

### --The device 2-2(Comparison device 4)-

An organic EL device 2-2 was fabricated in the same manner as the Elementary device 1-1, except that an electron injection layer of MoO₃ was formed with a thickness of 32nm.

### --The device 2-3 (corresponding to the device 1-5: Example 1)--

An organic EL device 2-3 was fabricated in the same manner as the Elementary device 1-1, except that an electron injection layer of Compound 4 was formed with a thickness of 32nm.

### --The device 2-4 (corresponding to the device 1-6: Example 2)--

An organic EL device 2-4 was fabricated in the same manner as the Elementary device 1-1, except that an electron injection layer of Compound 1 was formed with a thickness of 32nm.

### --The device 2-5(Example 3)--

An organic EL device 2-5 was fabricated in the same manner as the Elementary device 1-1, except that an electron injection layer of MoO₃ was formed with a thickness of 3nm.

### --The device 2-6 (Example 4)-

An organic EL device 2-6 was fabricated in the same manner as the Elementary device 1-1, except that an electron injection layer of AlF₃ was formed with a thickness of 1. 5nm and then another layer of Compound 4 was formed with a thickness of 30.5nm thereon.

### --The device 2-7(Example 5)--

An organic EL device 2-7 was fabricated in the same manner as the Elementary device 1-1, except that an electron injection layer of MoO₃ was formed with a thickness of 3nm and then another layer of Compound 1 was formed with a thickness of 32nm thereon.

### --The device 2-8(Example 6)--

An organic EL device 2-8 was fabricated in the same manner as the Elementary device 1-1, except that an electron injection layer of AlF₃ was formed with a thickness of 1. 5nm and then another layer of Compound 1 was formed with a thickness of 30. 5nm thereon.

### --The device 2-9(Comparison device 5)--

An organic EL device 2-9 was fabricated in the same manner as the Elementary device 1-1, except that an electron injection layer of MoO₃ was formed with a thickness of 3nm and then another layer of TPT-1 was formed with a thickness of 32nm thereon.

### --The device 2-10(Comparison device 6)--

An organic EL device 2-10 was fabricated in the same manner as the Elementary device 1-1, except that an electron injection layer of AlF₃ was formed with a thickness of 1. 5nm and then another layer of TPT-1 was formed with a thickness of 30.5nm thereon.

The device structures of the device 1-1 and from the device 2-2 to the device 2-10 are listed as follows.
Device No.: Anode /Hole injection layer /Hole transport layer /Light-emitting layer functioning as an electron transport layer /Electron injection layer /Cathode
The device 1-1: ITO/CuPc/NPB/Alq3/Li₂O/Al
The device 2-2: ITO/MoO₃/NPB/Alq3/Li₂O/Al
The device 2-3: ITO/Compound 4/NPB/Alq3/Li₂O/Al
The device 2-4: ITO/Compound I/NPB/Alq3/Li₂O/Al
The device 2-5: ITO/MoO₃·Compound 4/NPB/Alq3/Li₂O /Al
The device 2-6: ITO/AlF3·Compound 4/NPB/Alq3/Li₂O /Al
The device 2-7: ITO/MpoO₃·Compound 1/NPB/Alq3/Li₂O/Al
The device 2-8: ITO/AlF3·Compound 1/NPB/Alq3/Li₂O/Al
The device 2-9: ITO/MoO₃·TPT-1/NPB/Alq3/Li₂O/Al
The device 2-10: ITO/AlF3·TPT-1/NPB/Alq3/Li₂O/Al.

As for the devices 1-1, and 2-2 to 2-10, these were driven respectively under a condition of a predetermined current density of at a high temperature storage environment (85° C, 100° C, 100 hours), and then initial driving voltages, initial luminance, changes of driving voltage and changes of luminance of those devices were measured respectively.

The tested results are shown in the following Table 3. In the judgment of high temperature storage, the device having a change of driving voltage lower than +0.5V is denoted by ○, else ×. In the driving life span, the device having a performance equal to or higher than that of Elementary device 1-1(ref) in the luminance inferiority is denoted by ○, else ×. HILL and HIL2 represent electron injection layers and HTL represents the hole transport layer.

**Table 3**

| Device | HIL1 | HIL2 | HTL | Initial Driv. Volt. @ 7.5mA/cm² (V) | Initial lum. @ 7.5mA/cm² L(cd/m²) | High temp. storage (85°C) 100 hours | | Judgment (85°C) | Driv. life span@ 21mA/cm ² | Overall Judgment |
|---|---|---|---|---|---|---|---|---|---|---|
| | | | | | | Voltage change @ 7.5mA/cm² | Lum. change @ 7.5mA/cm² | | | |
| 1-1 (ref) | CuPc (32nm) | | NPB (38nm) | 5.52 | 310 | +0.1 | +3 | ○ | ○ | ref |
| 2-2 (Compar. 4) | MoO₃ (32nm) | | ↑ | 4.90 | 290 | +1.8 | -90 | × | × | × |
| 2-3 (Ex. 1) | Comp. 4 (32nm) | | ↑ | 3.73 | 287 | +1.4 | -55 | × | × | Δ |
| 2-4 (Ex. 2) | Comp. 1 (32nm) | | ↑ | 3.57 | 247 | +1.3 | +40 | × | × | Δ |
| 2-5 (Ex. 3) | MoO₃ (3nm) | Comp. 1 (29nm) | ↑ | 4.03 | 282 | +0.1 | +14 | ○ | ○ | ○ |
| 2-6 (Ex.4) | AlF₃ (1.5nm) | Comp. 1 (30.5nm) | ↑ | 3.81 | 281 | +0.2 | +13 | ○ | ○ | ○ |
| 2-7 (Ex. 5) | Mo0₃ (3nm) | Comp. 4 (29nm) | ↑ | 3.81 | 269 | +0.1 | +15 | ○ | ○ | ○ |
| 2-8 (Ex. 6) | AlF₃ (1.5nm) | Comp. 4 (30.5nm) | ↑ | 3.66 | 273 | +0.3 | +20 | ○ | ○ | ○ |
| 2-9 (Compar.5) | MoO₃ (3nm) | TPT-1 (29nm) | ↑ | 4.71 | 268 | +0.2 | +5 | ○ | ○ | × |
| 2-10 (Compar. 6) | AlF₃ (1.5nm) | TPT-1 (30.5nm) | ↑ | 4.91 | 290 | +0.6 | +32 | Δ | ○ | × |

As seen from these results, it is understood that the there are observed a little rise of driving voltages in the respective devices having the electron injection layer of a layered type including an extremely thin film of inorganic fluoride AlF₃ layer or inorganic oxide Mo0₃ layer and the borazine compound layer or the benzene compound layer, in comparison with those of using a single electron injection layer of the borazine compound or benzene compound. However, the two layered type devices can be driven with a low diving voltage lower than that of Elementary device 1-1 using the CuPc layer, and have durability in the high temperature storage and a long deriving life span with a suppressed deterioration of deriving property to exhibit a performance equal to Elementary device 1-1. These results show that the use of a layered inorganic compound for the electron injection layer improves a close adherence to a neighboring layer to secure the durability in the high temperature storage and a long deriving life span.

In addition, it is understood that the device using an AlF₃ layer has a tendency to be driven with a lower diving voltage in comparison with that of the device using a Mo0₃ layer.

### --Example 3: (Performance valuation of the device including, as an electron injection layer, a mixture layer of a bulky organic semiconductor compound and an inorganic compound)--

A plurality of organic EL devices were fabricated in a manner described bellow and then the life span properties thereof were measured and evaluated, each of which includes an electron injection layer in which an inorganic compound (inorganic fluoride, inorganic oxide) and a borazine compound (Compound 1) or benzene compound (Compound 4) are mixed.

Similarly to Example 1, the devices were based on Elementary device 1-1.

### --The device 3-2 (corresponding to the device 1-5: Example 1)--

An organic EL device 3-2 was fabricated in the same manner as the Elementary device 1-1, except that an electron injection layer of Compound 4 was formed with a thickness of 32nm.

### --The device 3-3 (corresponding to the device 1-6: Example 2)--

An organic EL device 3-3 was fabricated in the same manner as the Elementary device 1-1, except that an electron injection layer of Compound 1 was formed with a thickness of 32nm.

### --The device 3-4(Example 7)--

An organic EL device 3-4 was fabricated in the same manner as the Elementary device 1-1, except that an electron injection layer of Compound 1 to which TPT-1 was doped at 50vol% was formed with a thickness of 32nm.

### --The device 3-5(Example 8)--

An organic EL device 3-5 was fabricated in the same manner as the Elementary device 1-1, except that an electron injection layer of Compound 4 to which MoO₃ was doped at 5vol% was formed with a thickness of 32nm.

### --The device 3-6(Example 9)--

An organic EL device 3-6 was fabricated in the same manner as the Elementary device 1-1, except that an electron injection layer of Compound 4 to which Mo0₃ was doped at 10vol% was formed with a thickness of 32nm.

### --The device 3-7(Example 10)--

An organic EL device 3-7 was fabricated in the same manner as the Elementary device 1-1, except that an electron injection layer of Compound 4 to which Mo0₃ was doped at 20vol% was formed with a thickness of 32nm.

### --The device 3-8(Example 11)--

An organic EL device 3-8 was fabricated in the same manner as the Elementary device 1-1, except that an electron injection layer of Compound 4 to which Mo0₃ was doped at 40vol% was formed with a thickness of 32nm.

### --The device 3-9(Example 12)--

An organic EL device 3-9 was fabricated in the same manner as the Elementary device 1-1, except that an electron injection layer of Compound 4 to which AlF₃ was doped at 5vol% was formed with a thickness of 32nm.

### --The device 3-10(Example 13)--

An organic EL device 3-10 was fabricated in the same manner as the Elementary device 1-1, except that an electron injection layer of Compound 4 to which AlF ₃ was doped at 10vol% was formed with a thickness of 32nm.

### --The device 3-11(Example 14)--

An organic EL device 3-11 was fabricated in the same manner as the Elementary device 1-1, except that an electron injection layer of Compound 1 to which MoO₃ was doped at 5vol% was formed with a thickness of 32nm.

### --The device 3-12(Example 15)--

An organic EL device 3-12 was fabricated in the same manner as the Elementary device 1-1, except that an electron injection layer of Compound 1 to which Mo0₃ was doped at 10vol% was formed with a thickness of 32nm.

### --The device 3-13(Example 16)--

An organic EL device 3-13 was fabricated in the same manner as the Elementary device 1-1, except that an electron injection layer of Compound 1 to which Mo0₃ was doped at 25vol% was formed with a thickness of 32nm.

### --The device 3-14(Example 17)--

An organic EL device 3-14 was fabricated in the same manner as the Elementary device 1-1, except that an electron injection layer of Compound 1 to which AlF ₃ was doped at 2.5vol% was formed with a thickness of 32nm.

### --The device 3-15(Example 18)--

An organic EL device 3-15 was fabricated in the same manner as the Elementary device 1-1, except that an electron injection layer of Compound 1 to which AlF ₃ was doped at 5vol% was formed with a thickness of 32nm.

### --The device 3-16(Example 19)--

An organic EL device 3-14 was fabricated in the same manner as the Elementary device 1-1, except that an electron injection layer of Compound 1 to which AlF₃ was doped at 10vol% was formed with a thickness of 32nm.

### --The device 3-17(Comparison device 7)--

An organic EL device 3-17 was fabricated in the same manner as the Elementary device 1-1, except that an electron injection layer of TPT-1 to which Mo0₃ was doped at 5vol% was formed with a thickness of 32nm.

### --The device 3-18(Comparison device 8)--

An organic EL device 3-18 was fabricated in the same manner as the Elementary device 1-1, except that an electron injection layer of TPT-1 to which Mo0₃ was doped at 10vol% was formed with a thickness of 32nm.

### --The device 3-19(Comparison device 9)--

An organic EL device 3-19 was fabricated in the same manner as the Elementary device 1-1, except that an electron injection layer of TPT-1 to which Mo0₃ was doped at 20vol% was formed with a thickness of 32nm.

### --The device 3-20(Comparison device 10)--

An organic EL device 3-20 was fabricated in the same manner as the Elementary device 1-1, except that an electron injection layer of TPT-1 to which MoO₃ was doped at 40vol% was formed with a thickness of 32nm.

### --The device 3-21(Comparison device 11)--

An organic EL device 3-21 was fabricated in the same manner as the Elementary device 1-1, except that an electron injection layer of TPT-1 to which AlF₃ was doped at 5vol% was formed with a thickness of 32nm.

### --The device 3-22(Comparison device 12)--

An organic EL device 3-22 was fabricated in the same manner as the Elementary device 1-1, except that an electron injection layer of TPT-1 to which AlF ₃ was doped at 10vol% was formed with a thickness of 32nm.

### --The device 3-23(Comparison device 13)--

An organic EL device 3-23 was fabricated in the same manner as the Elementary device 1-1, except that an electron injection layer of TPT-1 to which AlF ₃ was doped at 20vol% was formed with a thickness of 32nm.

### --The device 3-24(Comparison device 14)--

An organic EL device 3-21 was fabricated in the same manner as the Elementary device 1-1, except that an electron injection layer of TPT-1 to which AlF ₃ was doped at 40vol% was formed with a thickness of 32nm.

The device structures of the device 1-1 and from the device 3-2 to the device 3-24 are listed as follows.
Device No.: Anode/Inorganic compound doped electron injection layer /Hole transport layer/Light-emitting layer functioning as an electron transport layer /Electron injection layer/Cathode
The device 1-1: ITO/CuPc/NPB/Alq3/Li₂O/Al
The device 3-2: ITO/Compound 4/NPB/Alq3/Li₂O /Al
The device 3-3: ITO/Compound 1/NPB/Alq3/Li₂O /Al
The device 3-4: ITO/50vol%TPT-1Compound 4/NPB/Alq3/Li₂O/Al
The device 3-5: ITO/5vol% MoO₃,Compound 4/NPB/Alq3/Li₂O/Al
The device 3-6: ITO/10vol% MoO₃·Compound 4/NPB/Alq3/Li₂O/Al
The device 3-7: ITO/20 vol% MoO₃·Compound 4/NPB/Alq3/Li₂O/Al
The device 3-8: ITO/40vol% MoO₃·Compound 4/NPB/Alq3/Li₂O/Al
The device 3-9: ITO/5vol%AlF3·Compound 4/NPB/Alq3/Li₂O /Al
The device 3-10: ITO/10vol%AlF3·Compound 4/NPB/Alq3/Li₂O/Al
The device 3-11: ITO/5vol% MoO₃·Compound 1/NPB/Alq3/Li₂O/Al
The device 3-12: ITO/10vol% MoO₃·Compound 1/NPB/Alq3/Li₂O/Al
The device 3-13: ITO/25vol% MoO₃·Compound 1/NPB/Alq3/Li₂O/Al
The device 3-14: ITO/2.5vol%AlF3·Compound 1/NPB/Alq3/Li₂O/Al
The device 3-15: ITO/5vol%AlF3·Compound 1/NPB/Alq3/Li₂O/Al
The device 3-16: ITO/10vol%AlF3·Compound 1/NPB/Alq3/Li₂O /A1
The device 3-17: ITO/5vol% MoO₃·TPT-1/NPB/Alq3/Li₂O/Al
The device 3-18: ITO/10vol% MoO₃,TPT-1/NPB/Alq3/Li₂O/Al
The device 3-19: ITO/20vol% MoO₃·TPT-1/NPB/Alq3/Li₂O/Al
The device 3-20: ITO/40vol% MoO₃·TPT-1/NPB/Alq3/Li₂O/Al
The device 3-21: ITO/5vol%AlF3·TPT-1/NPB/Alq3/Li₂O/Al
The device 3-22: ITO/10vol%A1F3·TPT-1/NPB/Alq3/Li₂O/Al
The device 3-23: ITO/20vol%AlF3·TPT-1/NPB/Alq3/Li₂O/Al
The device 3-24: ITO/40vo1%A1F3·TPT-1/NPB/Alq3/Li₂O/Al.

As for the devices 1-1, and 3-2 to 3-24, these were driven respectively under a condition of a predetermined current density of at a high temperature storage environment (85° C, 100° C, 100 hours), and then initial driving voltages, initial luminance, changes of drivingvoltage and changes of luminance of those devices were measured respectively.

The tested results are shown in the following Table 4. In the judgment of high temperature storage, the device having a change of driving voltage lower than +0.5V is denoted by ○, else X. In the driving life span, the device having a performance equal to or higher than that of Elementary device 1-1(ref) in the luminance inferiority is denoted by ○, else ×. HIL represents electron injection layers and HTL represents the hole transport layer.

**Table 4**

| Device | HIL1 | HTL | Initial Driv. volt. @ 7.5mA/cm² (V) | Initial lum. @ 7.5mA/cm² L (cd/m²) | High temp.storage (85°C) 100 hours | | Judgment (85°C) | Driv. life span@ 21mA/cm | Overall Judgment |
|---|---|---|---|---|---|---|---|---|---|
| | | | | | Voltage change@ 7.5mA/cm² | Lum. change@ 7.5mA/cm² | | | |
| 1-1 (ref) | CuPc (32nm) | NPB (38nm) | 5.52 | 310 | +0.1 | +3 | ○ | ○ | ref |
| 3-2 (Ex. 1) | Comp. 4 (32nm) | ↑ | 3.73 | 287 | +1.4 | -55 | × | × | Δ |
| 3-3 (Ex.2) | Comp. 1 (32nm) | ↑ | 3.57 | 247 | +1.3 | +40 | × | × | Δ |
| 3-4 (Ex. 7) | 50%TPT-1 · Comp. 1 (32nm) | ↑ | 4.35 | 286 | +4.5 | +50 | × | × | Δ |
| 3-5 (Ex. 8) | 5%MoO₃ · Comp. 4 (32nm) | ↑ | 3.81 | 282 | +0.15 | +14 | ○ | ○ | ○ |
| 3-6 (Ex. 9) | 10%MoO₃ · Comp. 4 (32nm) | ↑ | 3.82 | 276 | +0.15 | +23 | ○ | ○ | ○ |
| 3-7 (Ex. 10) | 20%Mo0₃ · Comp. 4 (32nm) | ↑ | 3.62 | 315 | ND | ND | ○ (ND) | ○ (ND) | ○ |
| 3-8 (Ex. 11) | 40% MoO₃ · Comp. 4 (32nm) | ↑ | 3.98 | 347 | ND | ND | ○ (ND) | ○ (ND) | ○ |
| 3-9 (Ex. 12) | 5%AlF₃ · Comp. 4 (32nm) | ↑ | 3.84 | 280 | +0.2 | +15 | ○ | ○ | ○ |
| 3-10 (Ex.13) | 10%AlF₉ · Comp. 4 (32nm) | ↑ | 4.36 | 281 | ND | ND | ○ (ND) | ○ | ○ |
| 3-11 (Ex. 14) | 5%MoO₃ · Comp.1 (32nm) | ↑ | 3.59 | 257 | +0.1 | +14 | ○ | ○ | ○ |
| 3-12 (Ex. 15) | 10%MoO₃ · Comp.1 (32nm) | ↑ | 3.58 | 265 | ND | ND | ○ (ND) | ○ | ○ |
| 3-13 (Ex. 16) | 25%MoO₃ · Comp. 1 (32nm) | ↑ | 3.73 | 270 | +0.1 | +12 | ○ | ○ (ND) | ○ |
| 3-14 (Ex. 17) | 2. 5%Alf₃ · Comp. 1 (32nm) | ↑ | 3.45 | 282 | ND | ND | ○ (ND) | ○ (ND) | ○ |
| 3-15 <Ex. 18> | 5%AlF₃ · Comp. 1 (32nm) | ↑ | 3.41 | 249 | +0.2 | +18 | ○ | ○ | ○ |
| 3-16 (Ex. 19) | 10%AlF₃ · Comp. 1 (32nm) | ↑ | 3.52 | 260 | ND | ND | ○ (ND) | ○ (ND) | ○ |
| 3-7 (Compar. 7) | 5% MoO₃ · TPT-1 (32nm) | ↑ | 4.86 | 278 | ND | ND | ND | ND | × |
| 3-18 (Compar. 8) | 10%MoO₃ · TPT- 1 (32nm) | ↑ | 4.92 | 274 | ND | ND | ND | ND | × |
| 3-19 (Compar. 9) | 20%MoO₃ · TPT-1 (32nm) | ↑ | 4.87 | 265 | +0.23 | +6 | ○ | ○ | × |
| 3-20 (Compar. 10) | 40%MoO₃ · TPT-1 (32nm) | ↑ | 4. 66 | 263 | ND | ND | ND | ○ | × |
| 3-21 (Compar. 11) | 5% AlF3 · TPT-1 (32nm) | ↑ | 5.33 | 303 | +0.8 | +37 | × | ND | × |
| 3-22 (Compar. 12) | 10%AlF3 · TPT-1 (32nm) | ↑ | 5. 20 | 285 | +0.9 | +38 | × | ND | × |
| 3-23 (Compar. 13) | 20%AlF3 · TPT-1 (32nm) | ↑ | 5.02 | 290 | ND | ND | ND | ND | × |
| 3-24 (Compar. 14) | 40%AlF3 · TPT-1 (32nm) | ↑ | 4.86 | 315 | ND | ND | ND | ○ | × |

As seen from these results, it is understood that the respective devices having the electron injection layer of a mixture type of MoO₃ and a borazine compound or benzene compound can be driven with a low diving voltage lower than that of Elementary device 1-1, and have durability in the high temperature storage and a long deriving life span with a suppressed deterioration of deriving property to exhibit a performance equal to Elementary device 1-1, in similar to the case of Example 2.

In addition, it is understood that the device of the mixture type of AlF₃ and the borazine compound or benzene compound has a tendency to be driven with a little lower diving voltage in comparison with that of the mixture type device using MoO₃.

### --Example 4: (Valuation of thickness dependency on the electron injection layer)--

A plurality of organic EL devices were fabricated in a manner described bellow while changing a thickness of the electron injection layer ranging from 0nm to 60nm and then the driving properties thereof were measured and the electron injection layer thickness dependency ware examined, each of which includes an electron injection layer in which the borazine compound (Compound 1) or 5%- MoO₃: doped borazine compound (Compound 1) are used.

The device 1-3 of Example 1 (without an electron injection layer) was used for a comparison device.

### --The device 4-2 (Example 20)--

An organic EL device 4-2 was fabricated in the same manner as the Elementary device 1-1, except that an electron injection layer of Compound 1 to which MoO₃ was doped at 5vol% was formed with a thickness of 10nm and then a hole transport layer of NPB was formed with a thickness of 60nm thereon.

### --The device 4-3 (corresponding to the device 3-13 : Example 14)--

An organic EL device 4-3 was fabricated in the same manner as the Elementary device 1-1, except that an electron injection layer of Compound 1 to which Mo0₃ was doped at 5vol% was formed with a thickness of 32nm and then a hole transport layer of NPB was formed with a thickness of 38nm thereon.

### --The device 4-4(Example 21)--

An organic EL device 4-4 was fabricated in the same manner as the Elementary device 1-1, except that an electron injection layer of Compound 1 to which Mo0₃ was doped at 5vol% was formed with a thickness of 60nm and then a hole transport layer of NPB was formed with a thickness of 10nm thereon.

### --The device 4-5(Example 22)--

An organic EL device 4-5 was fabricated in the same manner as the Elementary device 1-1, except that an electron injection layer of Compound 1 was formed with a thickness of 10nm and then a hole transport layer of NPB was formed with a thickness of 60nm thereon.

### --The device 4-6 (corresponding to the device 1-6: Example 2)--

An organic EL device 4-6 was fabricated in the same manner as the Elementary device 1-1, except that an electron injection layer of Compound 1 was formed with a thickness of 32nm and then a hole transport layer of NPB was formed with a thickness of 38nm thereon.

### --The device 4-7(Example 23)--

An organic EL device 4-7 was fabricated in the same manner as the Elementary device 1-1, except that an electron injection layer of Compound 1 was formed with a thickness of 60nm and then a hole transport layer of NPB was formed with a thickness of 10nm thereon.

The device structures of the device 1-3 and from the device 4-2 to the device 3-24 are listed as follows.
Device No.: Anode /Electron injection layer (a thickness of 0 nm to 60nm) /Hole transport layer (a thickness of 10nm to 70nm) /Light-emitting layer functioning as an electron transport layer /Electron injection layer/Cathode
The device 1-3: ITO/-/NPB (70rm)/Alq3/Li₂O /A1
The device 4-2: ITO/5vol% MoO₃·Compound 1 (10nm)/NPB (60nm) /Alq3/Li₂O/Al
The device 4-3: ITO/5vol% MoO₃·Compound 1 (32nm)/NPB (38nm) /Alq3/Li₂O/Al
The device 4-4: ITO/5vol% MoO₃·Compound 1 (60nm)/NPB (10nm)/Alq3/Li₂O /A1
The device 4-5: ITO/Compound 1 (10nm)/NPB (60nm)/Alq3/Li₂O/Al
The device 4-6: ITO/Compound 1 (32nm)/NPB (38nm)/Alq3/Li₂O/Al
The device 4-7: ITO/Compound 1 (60nm)/NPB (10nm)/Alq3/Li₂O/Al.

As for the devices 1-3, and 4-2 to 4-7, these were driven respectively under a condition of a predetermined current density of at a high temperature storage environment (85° C, 100° C, 100 hours), and then initial driving voltages, initial luminance, changes of driving voltage and changes of luminance of those devices were measured respectively.

The tested results are shown in the following Tables 5 and 6. HIL represents electron injection layers and HTL represents the hole transport layer.

**Table 5**

| Device | HIL | HTL | Initial Driv. voltage @ 7.5mA/cm² (V) | Initial lum. @ 7.5mA/cm² L (cd/m²) |
|---|---|---|---|---|
| | 5%-MoO3 - comP. 1 (nm) | NPB (nm) | | |
| 1-3 (Compar.2) | 0 | 70 | 4.40 | 323 |
| 4-2 (Ex. 20) | 10 | 60 | 4.02 | 261 |
| 4-3 (Ex. 14) | 32 | 38 | 3.59 | 257 |
| 4-4 (Ex. 21) | 60 | 10 | 4.01 | 243 |

**Table 6**

| Device | HIL | HTL | Initial Driv. voltages @ 7.5mA/cm² (V) | Initial lum. @7.5mA/cm² L(cd/m²) |
|---|---|---|---|---|
| | Comp. I (nm) | NPB (nm) | | |
| 1-3 (Compar.2) | 0 | 70 | 4.40 | 323 |
| 4-5 (Ex. 22) | 10 | 60 | 4.00 | 272 |
| 4-6 (Ex. 2) | 32 | 38 | 3.43 | 267 |
| 4-7 (Ex. 23) | 60 | 10 | 5.08 | 146 |

As seen from these results, it is understood that the respective devices having the electron injection layer of the borazine compound solely used can be driven with a low initial diving voltage and have a tendency to be driven with a diving voltage rising as increasing of thickness thereof. However there is a tendency to avoid the rise of diving voltage caused by increasing of thickness of the electron injection layer.

### --Example 5: (Valuation of anode material dependency on the Initial driving voltage)--

A plurality of organic EL devices were fabricated in a manner described bellow and then the driving properties thereof were measured and evaluated on the material of the anode contact with the electron injection layer, each of the anode includes ITO or Ag.

### --The device 5-1 (corresponding to the device 1-6: Example 2)--

There was provided a glass substrate on which an anode of transparent electrode ITO was formed. Through a vacuum deposition method, in sequence, a hole injection layer of Compound 1 with a thickness of 32nmwas formed on the anode, and then a hole transport layer of NPB with a thickness of 38nmwas formed on the hole injection layer, and then a light-emitting layer functioning as an electron transport layer of Alq3 with a thickness of 60nm was formed on the hole transport layer, and then an electron injection layer Li₂O and a cathode of A1 were formed thereon serially.

### --The device 5-2(Example 24)--

An organic EL device 5-2 was fabricated in the same manner as the Elementary device 5-1, except that an electrode of Ag as an anode was formed.

### --The device 5-3 (corresponding to the device 3-13: Example 14)--

An organic EL device 5-3 was fabricated in the same manner as the Elementary device 5-1, except that, on a glass substrate on which an anode of transparent electrode ITO was formed, by using a vacuum deposition method, in sequence, an electron injection layer of Compound 1 to which MoO₃ was doped at 5vol% was formed at a thickness of 32nm and then a hole transport layer of NPB with a thickness of 38nm was formed.

### --The device 5-4(Example 25)--

An organic EL device 5-4 was fabricated in the same manner as the Elementary device 5-3, except that an electrode of Ag as an anode was formed.

### --The device 5-5 (corresponding to the device 1-3: Comparison device 2)--

An organic EL device 5-5 was fabricated in the same manner as the Elementary device 5-1, except that, on a glass substrate on which an anode of transparent electrode ITO was formed, by using a vacuum deposition method, in sequence, an electron injection layer of NPB was formed at a thickness of 32nm and then a hole transport layer of NPB with a thickness of 38nm was formed.

### --The device 5-6(Comparison device 15)--

An organic EL device 5-6 was fabricated in the same manner as the Elementary device 5-5, except that an electrode of Ag as an anode was formed.

The device structures of from the device 5-1 to the device 5-6 are listed as follows.
Device No.: Anode /Hole injection layer/Hole transport layer /light-emitting layer functioning as an electron transport layer /Electron injection layer /Cathode
The device 5-1: ITO/Compound 1/NPB/Alq3/Li₂O /Al
The device 5-2: Ag/Compound 1/NPB/Alq3/Li₂O /Al
The device 5-3: ITO/5vol% MoO₃·Compound 1/NPB/Alq3/Li₂O /Al
The device 5-4: Ag/5vol% MoO₃·Compound 1/NPB/Alq³/Li₂O /Al
The device 5-5: ITO/NPB/NPB/Alq³/Li₂O /Al
The device 5-6: Ag/NPB/NPB/Alq3/Li₂O /Al.

As for the devices 5-1 to 5-6, these were driven respectively under a condition of a predetermined current density, and then initial driving voltages were measured respectively.

The tested results are shown in the following Table 7. HIL represents electron injection layers and HTL represents the hole transport layer.

**Table 7**

| Device | Anode | HTL | Initial Driv. voltage @7.5mA/cm² (V) |
|---|---|---|---|
| 5-1 (Ex. 2) | ITO | Comp. 1 | 3.57 |
| 5-2 (Ex. 24) | Ag | ↑ | 13.1 |
| 5-3 (Ex. 14) | IT0 | 5%Mo0₃·Comp· 1 | 3.59 |
| 5-4 (Ex. 25) | Ag | ↑ | 4.19 |
| 5-5 (Compar.2) | IT0 | NPB | 4.40 |
| 5-6 (Compar. 15) | Ag | ↑ | 13.8 |

As seen from these results, it is understood that the respective devices having the electron injection layer of the borazine compound used can be driven with a low diving voltage and suffers an influence of electrode materials. Whereas, the device including the electron injection layer doped with MoO₃ was not dependent much on the sort of electrode materials in the initials driving characteristics.

### --Example 6: (Performance valuation of the device using a bulky organic semiconductor compound as an electron transport layer)--

A plurality of organic EL devices were fabricated in a manner described below and then the driving properties thereof were measured and evaluated, each of which includes an electron injection layer containing a bulky organic semiconductor compound of a benzene compound.

The devices were based on Elementary device 1-1.

### --The device 6-2(Example 26)--

An organic EL device 6-2 was fabricated in the same manner as the Elementary device 1-1, except that a light-emitting of Alq3 was formed with a thickness of 30nm and then an electron transport layer of Compound 4 was formed with a thickness of 30nm thereon.

### --The device 6-3(Example 27)--

An organic EL device 6-3 was fabricated in the same manner as the Elementary device 1-1, except that a light-emitting of Alq3 was formed with a thickness of 30nm and then an electron transport layer of Compound 4 was formed with a thickness of 25nm thereon and then another layer of Alq3 was formed with a thickness of 5nm thereon.

The device structures of the device 1-1 and from the device 6-2 to the device 6-3 are listed as follows.
Device No.: Anode/Hole injection layer/Hole transport layer /Light-emitting layer /Electron transport layer /Electron injection layer /Cathode
The device 1-1: ITO/CuPc/NPB/Alq3/-/Li₂O/Al
The device 6-2: ITO/CuPc/NPB/Alq3/Compound 4/Li₂O/Al
The device 6-3: ITO/CuPc/NPB/Alq3/Compound 4/Alq3/Li₂O/Al.

As for the devices 1-1, 6-2 and 6-3 , these were driven respectively under a condition of a predetermined current density, and then initial driving voltages were measured and observed in outward appearance respectively.

The tested results are shown in the following Table 8 and FIG. 10 (the device 6-2) and FIG. 11 (the device 6-3). EML represents the light-emitting layer and ETL represents the electron transport layer.

**Table 8**

| Device | EML/ETL | Initial Driv. voltage @7.5mA/cm² (V) | Initial lum. @7.5mA/cm² L(cd/m²) |
|---|---|---|---|
| 1-1 (ref) | Alq₃ 60nm | 5.72 | 309 |
| 6-2 (Ex. 26) | Alq₃/Comp. 4 30nm/30nm | 7.98 | 279 |
| 6-3 (Ex.27) | Alq₃/Comp.4/Alq₃ layer 30nm/25nm/5nm | 5.45 | 322 |

As seen from these results, it is understood that the there are observed an excellent light emission from the device having the layered Alq3/the benzene compound /Alq3 and the usability of the electron transport layer in which the benzene compound sandwiched between the electric charge-transporting material layers. It is expected that the bulky organic semiconductor compound layer made of the benzene compound or borazine compound sandwiched between the electric charge-transporting material exhibits an electron transporting characteristics. It is understood that the organic semiconductor layer containing the bulky organic semiconductor compound of the benzene compound or the borazine compound is suitably placed as a hole transport layer or electron injection layer between the light-emitting layer and the anode.

On the basis of the foregoing Examples, as for the bulky organic semiconductor compounds of the benzene compound and the borazine compound, there ware examined using a MOPAC calculation to make a 3-D structure simulation (a central skeleton and aromatic substituents with a dihedral angle with respect to the central skeleton connected thereto).

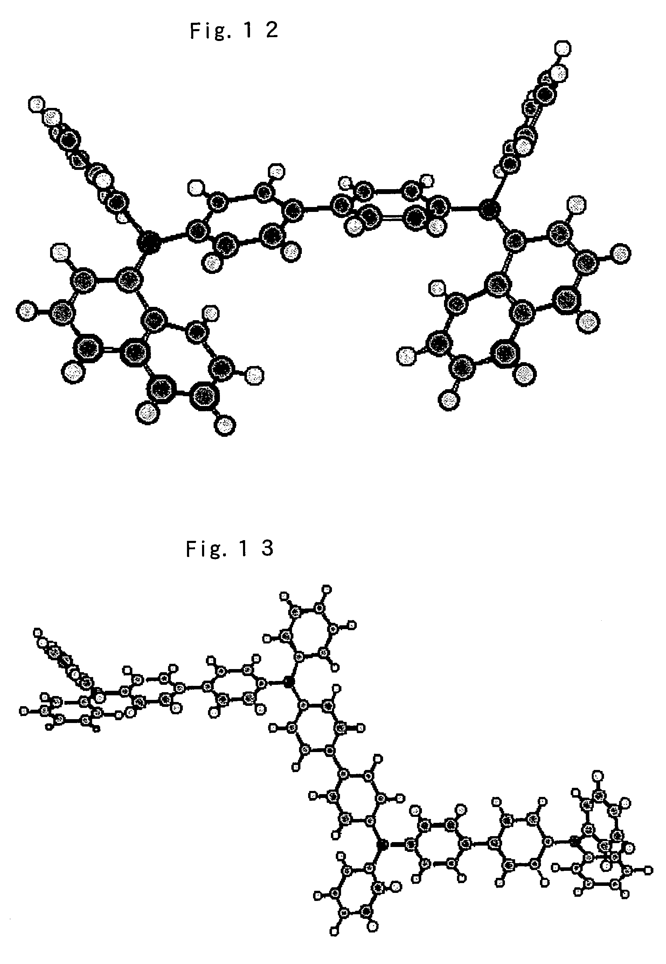

The respective compounds of NPB (Comparison device 2) and TPT-1 (Comparison device 1) represented by the following chemical formulas are aggregates of rings in which the central skeleton and the substituents having the dihedral angle do not exist inherently, and there is few case that the substituent have a dihedral angle larger than 70° respect to the central skeleton. FIGS. 12 and 13 show illustrations of Molecular Orbital (MO) for these compounds drawn by using a MOPAC (Molecular Orbital PACkage) computer program.

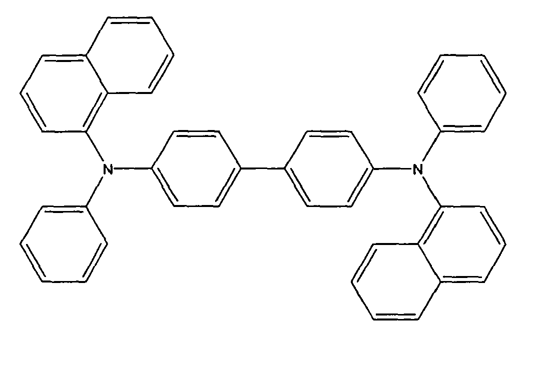

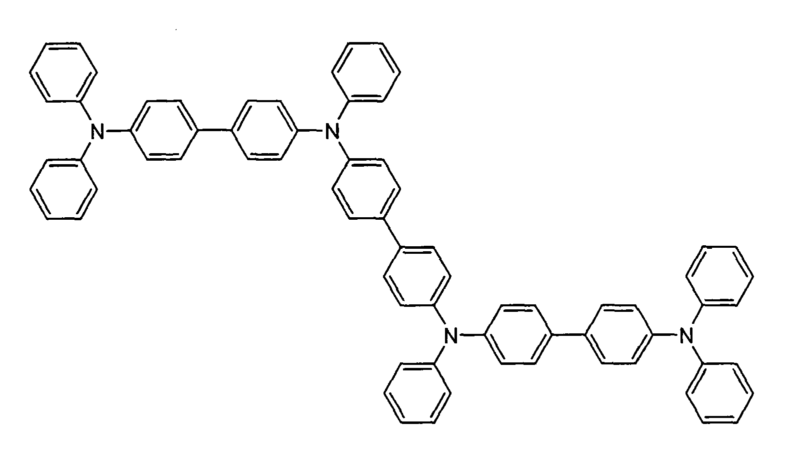

In addition, the cyclopentadiene derivative (Comparison device 3) has the central skeleton ring without aromaticity, such a ring is collapsed in plainness as shown in FIG. 14.

Therefore, it is preferable that an aromatic multi-membered ring structure of the bulky organic semiconductor compound has aromaticity as an electric charge-transporting material and further, each of the aromatic substituents is arranged in a manner that a dihedral angle between a ring plane of the aromatic multi-membered ring structure and the ring plane of the aromatic substituent is within 70 to 90° . Moreover, It is preferable that the sum of the ring planes of the aromatic substituents is larger than that of the ring plane of the aromatic multi-membered ring structure, each ring plane of the aromatic substituent having a dihedral angle of 70 to 90° with respect to the ring plane of the aromatic multi-membered ring structure.

In other words, the usage (as at least of hole injection material)of a layer including the aromatic substituents is arranged in a manner that a dihedral angle between a ring plane of the aromatic multi-membered ring structure and the ring plane of the aromatic substituent is within 70 to 90°can realize to allow a low driving voltage of the device regardless of HOMO (highest energy occupied molecular orbital) and mobility as discussed for a long time, although such a compound has a deep HOMO and a slow charge mobility. It is imagined from the foregoing results that the aromatic substituent of the benzene compound and the borazine compound has an orientation with respect to the interface contacting the other layer, so that the dielectric relaxation caused by the orientation polarization reduces the interface trap level of obstruction to decrease a driving voltage resulting in decreasing of a hole injection barrier and improvement of the hole injection characteristics, although such a detail principle is not clear

### [EXPLANATION OF REFERENCE NUMERALS]

- 1: Substrate
- 2: Anode
- 3: Hole injection layer
- 4: Hole transport layer
- 5: Light emitting layer
- 6: Electron transport layer
- 7: Electron injection layer
- 8: Cathode
- 51: Light-emitting layer as an electron transport layer

## Claims

1. An organic electroluminescence device comprising:
a pair of anode and cathode opposed to each other; and
a plurality of organic semiconductor layers layered or disposed between the anode and the cathode, the organic semiconductor layers including an light-emitting layer,
wherein at least one of the organic semiconductor layers contains a bulky organic semiconductor compound having an aromatic multi-membered ring structure and at least three aromatic substituents bonded thereto,
wherein determined by a semiempirical molecular orbital calculation method.

2. The organic electroluminescence according to claim 1, wherein the organic semiconductor layer including the bulky organic semiconductor compound is placed as a hole transport layer or hole injection layer between the light-emitting layer and the anode.

3. The organic electroluminescence according to claim 1 or 2, wherein the organic semiconductor layer including the bulky organic semiconductor compound is placed as an electron transport layer or electron injection layer between the light-emitting layer and the cathode.

4. The organic electroluminescence according to any one of claims 1 to 3, wherein the bulky organic semiconductor compound is a borazine compound in which the aromatic multi-membered ring structure is a borazine ring structure.

5. The organic electroluminescence according to any one of claims 1 to 3, wherein the bulky organic semiconductor compound is a benzene compound in which the aromatic multi-membered ring structure is a benzene ring structure.

6. The organic electroluminescence according to any one of claims 1 to 5, wherein a sum of areas of the ring planes of the aromatic substituents is larger than an area of the ring plane of the aromatic multi-membered ring structure in the bulky organic semiconductor compound.

7. The organic electroluminescence according to any one of claims 1 to 6, wherein the organic semiconductor layer containing the bulky organic semiconductor compound or a neighboring layer thereof contains an inorganic fluoride.

8. The organic electroluminescence according to claim7,wherein the inorganic fluoride is AlF₃ or MgF₂.

9. The organic electroluminescence according to claim 7 or 8, wherein the inorganic fluoride is doped with 5 to 40vol%.

10. The organic electroluminescence according to claim 9, wherein the inorganic fluoride is doped with 2.5 to 40vol%.

11. The organic electroluminescence according to any one of claims 1 to 6, wherein the organic semiconductor layer containing the bulky organic semiconductor compound or a neighboring layer thereof contains an inorganic oxide.

12. The organic electroluminescence according to claim 11, wherein the inorganic oxide is molybdenum oxide or vanadium oxide.

13. The organic electroluminescence according to claim 11 or 12, wherein the inorganic oxide is doped with 5 to 40vol%.

14. The organic electroluminescence according to claim 13, wherein the inorganic oxide is doped with 2.5 to 40vol%.

15. The organic electroluminescence according to any one of claims 1 to 14, wherein at least one of the cathodes is transparent or semi-transparent.
